Europäisches Patentamt

European Patent Office

Office européen des brevets

(11) Publication number: **0 180 674**
**B1**

# EUROPEAN PATENT SPECIFICATION

(45) Date of publication of patent specification: **30.08.89**

(21) Application number: **84307776.9**

(22) Date of filing: **09.11.84**

(51) Int. Cl.⁴: **H 05 K 5/02, H 05 K 7/02**

(54) Semiconductor device.

(43) Date of publication of application:
**14.05.86 Bulletin 86/20**

(45) Publication of the grant of the patent:
**30.08.89 Bulletin 89/35**

(84) Designated Contracting States:
**DE FR GB**

(56) References cited:
**EP-A-0 104 982**
**FR-A-1 602 493**
**US-A-4 423 465**

**IBM TECHNICAL DISCLOSURE BULLETIN, vol.
26, no. 6, November 1983, pages 2901-2902,
New York, US; R.C. LYNCH et al.:
"Electromechanical connector for modular
terminal"**

(73) Proprietor: **FUJI ELECTRIC CO., LTD.
1-1, Tanabeshinden, Kawasaki-ku
Kawasaki-shi Kanagawa 210 (JP)**

(72) Inventor: **Sekiya, Tsuneto
B303 180-10 Yokota
Matsumoto-shi Nagano-ken, 390 (JP)**
Inventor: **Matsuura, Osamu
3-7 Arigasaki 6-chome
Matsumoto-shi Nagano-ken, 390 (JP)**
Inventor: **Huruhata, Shooichi
Ooaza-Wada 4298-1
Matsumoto-shi Nagano-ken, 390-12 (JP)**

(74) Representative: **Gordon, Martin et al
G.F. Redfern & Company Marlborough Lodge 14
Farncombe Road
Worthing West Sussex, BN11 2BT (GB)**

Courier Press, Leamington Spa, England.

## Description

This invention relates to a semiconductor device and in particular to semiconductor devices assembled from a plurality of modules such as a power transistor circuit module or thyristor circuit module in combination with a driving circuit module.

The trend is for semiconductor devices comprising semiconductor elements and other circuit elements to become increasingly modular. Thus power transistor circuits and thyristor circuits as well as driving and protective circuits, which have heretofore been provided on separate printed circuit boards, are combined in the same package to achieve modularity. However, this has given rise to problems. Taking a power transistor circuit as an example of a high-temperature element, although the power transistor as a semi-conductor element is resistant to heat up to a temperature of 150°C, a protective circuit such as a snubber circuit including capacitors, for instance, is a low temperature item, resistant to heat only up to a temperature of approximately 100°C. For this reason, if they are combined in the same package, the guaranteed temperature limit must be at the lower limit and this detracts from the nominal operating characteristics of the semiconductor element.

It is an object of the present invention to provide a modular semiconductor device without detracting from the operating characteristics of high-temperature semiconductor elements in the device so as to at least maintain the intrinsic temperature limit characteristics of the semiconductor elements themselves.

According to this invention there is provided a semiconductor device comprising first and second encapsulated semiconductor modules containing respective arrangements of circuit elements and having first and second operating-temperature limits respectively, said second limit being lower than said first limit, said modules having been designed and constructed with regard to their optimum operating-temperature limits, such that they can operate to those limits in said devices, and being capable of being tested separately to their respective operating-temperature limits whereby such testing of the first module causes no damage to the second module, the first module having a casing made of a higher thermal resistance material than the second module.

Preferably means for mechanically interconnecting said modules is also arranged to provide electrical interconnections between the modules.

Advantageously it may be arranged that said modules are mechanically interconnected by means of a projecting keying portion of one of the modules engaging a recessed keying portion of another of the modules.

Conveniently it may be provided that a screw or similar securing member is arranged to secure the two modules together via aligned bores in the two modules.

Embodiments of this invention will now be described, by way of example, with reference to the accompanying drawings in which:—

Fig. 1 is a perspective exploded view of a semiconductor device in a first embodiment of this invention;

Fig. 2 is a perspective view of the assembled device shown in Fig. 1; and

Figs. 3 to 5 are respective exploded views of different forms of semiconductor device in second, third and fourth embodiments of this invention.

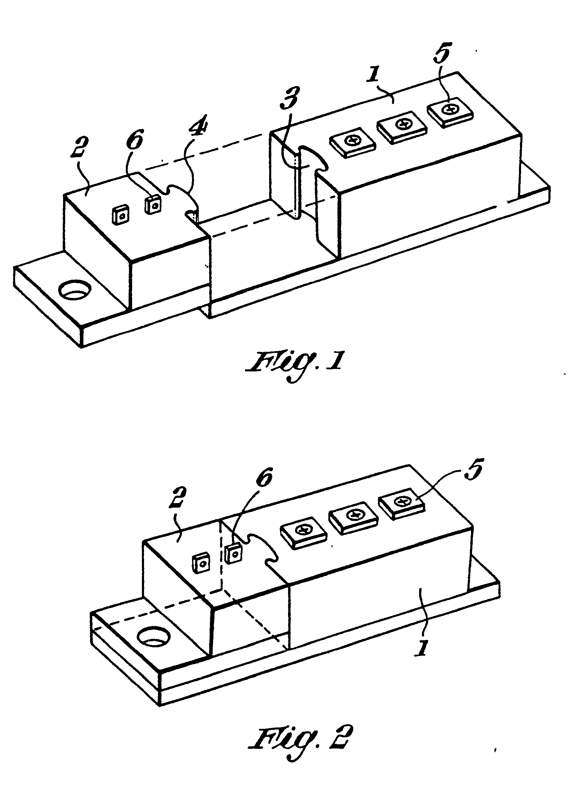

As shown in Figs. 1 and 2, a resin casing (encapsulation) 1 containing a power transistor and a resin casing 2 containing an associated circuit are combined together in a larger module by engaging a recessed keying portion 3 in the casing 1 by means of a projecting keying portion 4 of the casing 2. In order to interconnect the associated circuit and the power transistor, metal terminals 5 such as the emitter, base and collector terminals arranged to be exposed on the surface of the resin casing 1, are made to communicate with one another by means of external conductors (not shown). The resin casing 1 contains no capacitor or other component having a relatively low allowable temperature limit so that the module represented by the casing 1 can be tested at relatively high temperatures. Whereas the resin casing 2 contains the required circuit elements having relatively low allowable temperature limits and may be tested only at relatively low temperatures. Since the power transistor and the associated circuit can thus be separately tested and combined together later, this embodiment provides advantages of enhanced yield and device reliability. Moreover, a resin offering excellent heat resistance is used for only the module comprising the resin casing 1 designed to cope with high temperatures, so that the operating efficiency of the module is enhanced since the power transistor can be made operational at relatively high temperatures.

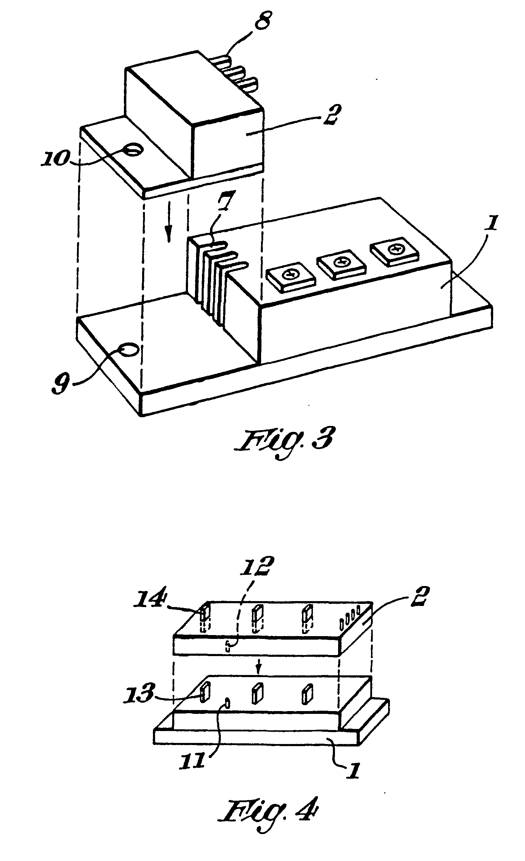

In the embodiment shown in Figs. 1 and 2, the associated circuit module and the power transistor module are interconnected by means of wiring outside the resin casings. In such an arrangement, a natural oscillation phenomenon may occur depending on the length and pattern of wiring. In Fig. 3 there is shown an embodiment in which such wiring can be dispensed with, in that metal-lined slits 7 are provided in the resin casing 1 and metal projections 8 of the associated circuit module can be fitted into the slits 7. Since the open metal-lined slits 7 and the metal projections 8 are so arranged as to electrically communicate with the components and circuits within the casings, the casings 1 and 2 can be assembled by inserting the projections 8 into the slits 7 from above and securing the modules together (to form a larger module) by means of a screw or other fastening engaging holes 9, 10 in the casings 1, 2 respectively using a hole 9 in the casing 1 and another 10 in the casing 2. In this way, the power transistor module and the associated circuit module may be interconnected electrically and combined without the necessity for external wiring. Thus a combination of the embodiments shown in Figs. 1 and 2 and Fig. 3 might be made so that the keying portions 3, 4 and the electrical connections 7, 8 may both be provided and in fact the connections 7, 8 may act as keying portions and the keying portions 3, 4 may act as electrical connections like the connections 7, 8.

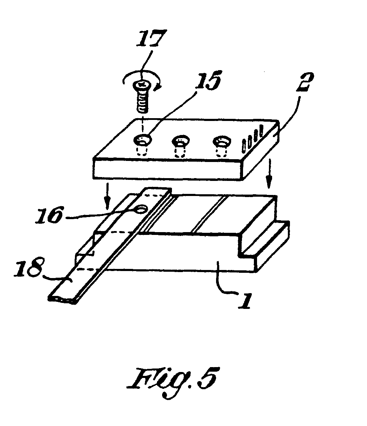

In Fig. 4 there is shown another embodiment of the present invention wherein external wiring has been dispensed with. A resin casing 1 containing the high-temperature semiconductor elements forms a stacked arrangement with a resin casing 2 containing an associated low-temperature circuit and the associated circuit and the semiconductor elements are oriented relative to one another for electrical interconnection by means of a pin 11 projecting from the casing 1 into a socket embedded in the casing 2. Main terminals such as 13 of the lower module are fitted from below into main terminals such as 14 projecting upwardly from the surface of the casing 2 so that external connections can be made via the main terminals such as 14.

In still another embodiment of the present invention that is shown in Fig. 5, two module casings 1, 2 in a stacked arrangement are secured together by means of set screws 17 (only one of which is shown) engaging holes 15 in the resin casing 2 and the screw-threadedly engaging internally screw-threaded bores 16 (only one of which is shown) in the resin casing 1. Electrical interconnection of the modules is simultaneously effected by means of the set screws 17 and external circuit connections can be provided by inserting wiring bus bars 18 between the modules and arranged to make electrical contact with respective ones of the set screws.

As described above, circuit elements having relatively high allowable temperature limits and associated circuit elements having relatively low allowable temperatures are contained in individual modules and assembled by means of appropriate mechanical and electrical coupling means. This has the advantage that the various modules are designed and constructed for their optimum temperature characteristics without being intrinsically compromised by being combined in the same basic module as components having inferior temperature characteristics. The advantage is also obtained that each module can be tested within its own allowable temperature range before being combined with other modules so that improvements can be obtained in yield and product reliability. If the modules are so arranged as to be assembled together and simultaneously electrically connected trouble over external wiring can be avoided and reliability relative to wire connections will be improved. The problem of natural oscillation due to the wire connections can also be effectively minimised.

## Claims

1. A semiconductor device comprising first and second encapsulated semiconductor modules containing respective arrangements of circuit elements and having first and second operating-temperature limits respectively, said second limit being lower than said first limit, said modules having been designed and constructed with regard to their optimum operating-temperature limits, such that they can operate to those limits in said device, and being capable of being tested separately to their respective operating-temperature limits whereby such testing of the first module causes no damage to the second module, the first module having a casing made of a higher thermal resistance material than the second module.

2. A semiconductor device according to claim 1, wherein the first module comprises a power transistor circuit module or thyristor circuit module and the second module comprises a driving circuit module or snubber circuit.

3. A semiconductor device according to claim 1 or claim 2, wherein said first and second operating-temperature limits are 150°C and 100°C respectively.

4. A semiconductor device as claimed in claim 1, wherein means for mechanically interconnecting said modules is also arranged to provide electrical interconnections between the modules.

5. A semiconductor device as claimed in claim 1 or claim 2, wherein said modules are mechanically interconnected by means of a projecting keying portion of one of the modules engaging a recessed keying portion of another of the modules.

6. A semiconductor device as claimed in any one of the preceding claims wherein a screw or securing member is arranged to secure the two modules together via aligned bores in the two modules.

7. A semiconductor device as claimed in any one of the preceding claims wherein external connections are provided by means of electrically conductive members clamped between at least two of the modules.

## Patentansprüche

1. Halbleiteranordnung bestehend aus ersten und zweiten eingekapselten Halbleitermodulen, die entsprechende Schaltelemente enthalten und die entsprechende erste und zweite Betriebstemperaturgrenzen besitzen, wobei die zweite Grenze niedriger als die erste Grenze ist und wobei die Module auf ihre optimale Betriebstemperaturgrenze ausgebildet und ausgelegt sind, so daß sie bis zu diesen Grenzen in der Anordnung arbeiten können und die getrennt auf ihre Betriebstemperaturgrenzen getestet werden können, wobei der Test des ersten Moduls keine Beschädigung des zweiten Moduls bewirkt und wobei das erste Modul ein Gehäuse aus einem thermisch widerstandsfähigerer Material besitzt als das des zweiten Moduls.

2. Halbleiteranordnung nach Anspruch 1, wobei das erste Modul einen Transistorarbeitsstromkreismodul oder einen Thyristorkreismodul und der zweite Modul einen Antriebsstromkreismodul oder Dämpfungsstromkreismodul enthält.

3. Halbleiteranordnung nach Anspruch 1 oder 2, wobei die Betriebstemperaturgrenzen 150°C bzw. 100°C sind.

4. Halbleiteranordnung nach Anspruch 1, wobei Mittel zum mechanischen Verbinden der Module auch zur Schaffung der elektrischen Verbindung zwischen den Modulen dienen.

5. Halbleiteranordnung nach einem der Ansprüche 1 oder 2, wobei die Module mechanisch durch einen vorspringenden Federabschnitt an einem Modul, der in einen Nutabschnitt am anderen Modul eingreift, verbunden sind.

6. Halbleiteranordnung nach einem der vorstehenden Ansprüche, wobei eine Schraube oder ein Sicherungsteil vorgesehen ist, um die zwei Module über ausgerichtete Bohrungen in den beiden Modulen zusammenzuhalten.

7. Halbleiteranordnung nach einem der vorstehenden Ansprüche, wobei externe Verbindungen vorgesehen sind in Form von elektrisch leitenden Teilen, die zwischen wenigstens zwei der Module geklammert sind.

**Revendications**

1. Dispositif à semiconducteurs comportant des premier et second modules à semiconducteurs encapsulés contenant des agencements respectifs d'éléments de circuit et possédant des première et seconde limites de température de fonctionnement respectivement, ladite seconde limite étant inférieure à ladite première limite, lesdits modules ayant été conçus et réalisés en ce qui concerne leurs limites de température de fonctionnement optimales, de telle sorte qu'ils peuvent fonctionner à ces limites dans ledit dispositif, et povuant être contrôlés séparément à leurs limites respectives de température de fonctionnement de telle sorte qu'un tel contrôle du premier module ne provoque aucun dommage au second module, le premier module possédant un boîtier réalisé en un matériau à résistance thermique plus élevéee que le second module.

2. Dispositif à semiconducteurs selon la revendication 1, dans lequel le premier module comporte un module de circuit à transistor de puissance ou un module de circuit à thyristor et le second module comporte un module de circuit de commande ou un circuit amortisseur.

3. Dispositif à semiconducteurs selon la revendication 1 ou la revendication 2, dans lequel lesdites première et seconde limites de température de fonctionnement sont 150°C et 100°C respectivement.

4. Dispositif à semiconducteurs selon la revendication 1, dans lequel des moyens pour relier entre eux mécaniquement lesdits modules sont également agencés pour assurer des interconnexions électriques entre les modules.

5. Dispositif à semiconducteurs selon la revendication 1 ou la revendication 2, dans lequel lesdits modules sont reliés entre eux mécaniquement au moyen d'une partie saillante de clavetage d'un des modules pénétrant dans une partie évidée de clavetage d'un autre des modules.

6. Dispositif à semiconducteurs selon l'une quelconque des revendications précédentes, dans lequel une vis ou élément de fixation est agencé pour fixer les deux modules l'un à l'autre par l'intermédiaire de trous alignés dans les deux modules.

7. Dispositif à semiconducteurs selon l'une quelconque des revendications précédentes, dans lequel des connexions externes sont prévues au moyen d'éléments électriquement conducteurs bloqués entre au moins deux des modules.

Fig. 1

Fig. 2

1

**Fig. 3**

**Fig. 4**

*Fig.5*